Europäisches Patentamt

European Patent Office

Office européen des brevets

(11) Publication number: **0 173 566**
**A2**

(12) **EUROPEAN PATENT APPLICATION**

(21) Application number: **85306113.3**

(22) Date of filing: **29.08.85**

(51) Int. Cl.⁴: **H 01 L 29/165,** H 01 L 21/205,
H 01 L 31/02

(30) Priority: **29.08.84 US 645334**

(71) Applicant: **Exxon Research and Engineering Company,
P.O.Box 390 180 Park Avenue, Florham Park New
Jersey 07932 (US)**

(72) Inventor: **Tiedje, John Thomas, RD 4, 6 Evergreen Court,
Lebanon New Jersey 08833 (US)**
Inventor: **Abeles, Benjamin, RD1, Pine Hill Road,
Annandale New Jersey 08801 (US)**

(74) Representative: **Mitchell, Alan et al, ESSO Engineering
(Europe) Ltd. Patents & Licences Apex Tower High
Street, New Malden Surrey KT3 4DJ (GB)**

(43) Date of publication of application: **05.03.86
Bulletin 86/10**

(84) Designated Contracting States: **DE FR GB**

(54) **Multi-layered material having graded properties.**

(57)  A multi-layer material is disclosed in which the layers
forming the structure are made of semiconductor or insulator
material with conduction and valence band edge energies
that are spatially periodic due to the compositional modula-
tion associated with the individual layers, the structure
having at least two periodic repeat distances and the ma-
terial formed from tetrahedrally bonded elements or alloys
containing said tetrahedrally bonded elements.

MULTI-LAYERED MATERIAL HAVING GRADED PROPERTIES

This invention relates to multi-layered material comprised of semiconductor or insulator material.

Layered crystalline semiconductor materials with periodic variations in composition in one dimension on the scale of 5-500A commonly known as superlattice structures (Esaki U.S. 3,626,257) have been found to exhibit many novel properties with numerous technological applications. In these materials good semiconducting properties, such as carrier mobilities and minority carrier lifetimes that are comparable to high quality bulk samples of the individual components require that the successive layers be grown epitaxially as single crystal sheets. This requirement is not easy to satisfy in practice and normally limits the composition of crystalline semiconductor superlattices to semiconductors and semiconductor alloys that are lattice matched or nearly lattice matched, and that can be deposited stoichiometrically by the techniques of thin film deposition. The degree of crystallinity of the superlattice material is then limited by the perfection of the substrate material and the ability of the deposited layers to replicate the underlying layers.

A further complication well-known in the art (see for example Dingle U.S. 4,261,771) is that even if the individual semiconductors comprising the intended superlattice material are lattice matched and can be deposited epitaxially as stoichiometric films, standard growth conditions still may not produce a superlattice material with substantially smooth layers since surface diffusion effects and nucleation effects may cause the semiconductor layers to grow in a columnar fashion or otherwise non-uniformly in the lateral direction perpendicular to the plane of the substrate. In this case it is unlikely that layered semiconductor films could be fabricated comprising individual sublayers that are coherent laterally and substantially smooth on the scale of a few interatomic distances. The mechanisms of thin film nucleation and growth are characteristically complex, in that they depend frequently in unexpected ways on the growth conditions such as the substrate temperature and the detailed structure and chemistry of the substrate surface. Thus, in general, one cannot predict what classes of materials or growth conditions can be used to fabricate superlattice structures.

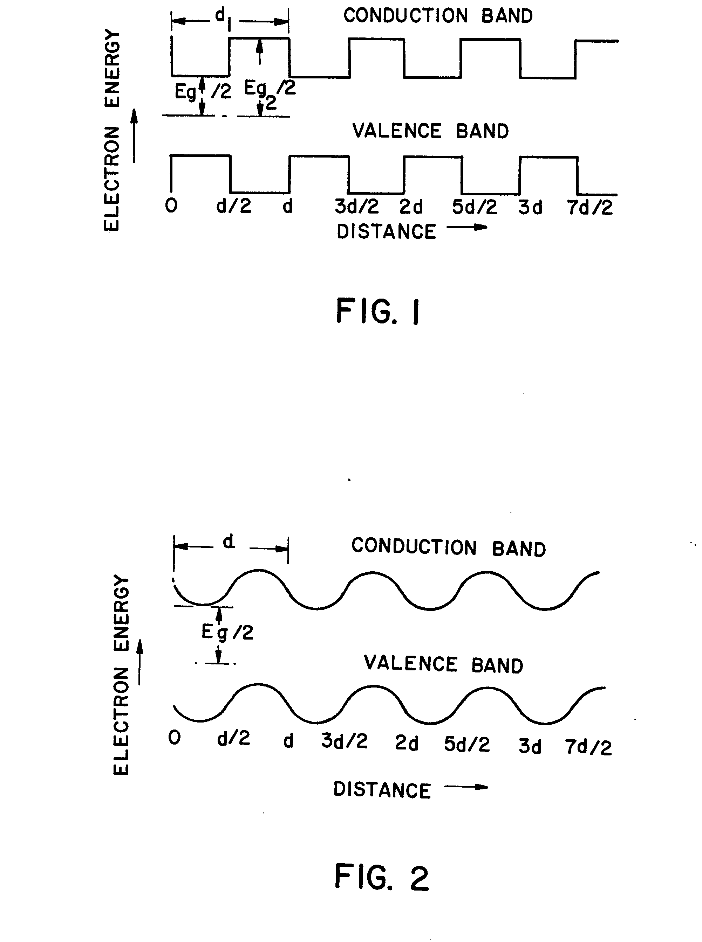

Two classes of compositionally modulated crystalline semiconductor superlattice materials have been studied extensively in the prior art. In the first class, $GaAs/Ga_{1-x}Al_xAs$ being an example, the individual sublayers comprise two different semiconductor materials or alloys with different physical properties such as band gap, melting point or resistance to ionic diffusion. In the second class, GaAs nipi structures being an example, the individual sublayers differ only in the concentration of electrically active dopant atoms. Superlattice materials in this category include n-i-p-i... p-i-p-i ..., n-i-n-i ..., p-n-p-n ... structures where n, i, and p are n-type, intrinsic and p-type sublayers. Examples of energy band diagrams for the two classes of superlattice materials described above are shown in Fig. 1 and 2.

Figure 1 shows a schematic energy-band diagram of a semiconductor superlattice structure having undoped crystalline layers where the alternating layers have substantially different compositions and the thickness of each layer is d/2.

Figure 2 shows a schematic energy-band diagram of a superlattice structure having alternating layers, whose composition differs only in the dopant content, such as would be obtained in a n-i-p-i-n-i-p-i structure for example. See, for example, L. Esaki et al., U.S. 3,626,357 and R. Dingle et al., U.S. 4,163,237.

Another advance in the field of materials science relating to semiconductor technology in recent years has been the discovery that amorphous semiconductors and insulators can be deposited by a variety of means, reactive sputtering and plasma-assisted chemical vapor deposition (PCVD) being the most popular, in the amorphous state in a substantially defect-free form (PCVD is also known as glow discharge deposition.) By substantially defect-free we mean free of chemically and electrically active coordination defects such as dangling bonds, to a level of better than about 1 defect per $10^5$ atoms. This defect-free property manifests itself as a low density of states in the gap, as measured for example, by the optical absorption coefficient for photons with an energy less than the optical bandgap. In one of the more thoroughly studied materials, namely amorphous silicon deposited by plasma assisted CVD from silane gas, the low density of defects is known to result from the passivation of dangling Si bonds by atomic hydrogen. The hydrogen content of these materials depends on the deposition conditions. The materials will be represented by the nomenclature a-Si:H, in the case of amorphous hydrogenated silicon, where the hydrogen content is understood to depend on the detailed nature of the film preparation process.

The present invention provides, from one aspect, a multilayered material, for example with non-periodic layers, having graded properties wherein the layers forming the material are made of semiconductor or insulator material, which may for example be amorphous, the interfaces between said layers being smooth and having a thickness less than about 500A, for example less than about 5A.

The present invention provides from another aspect a multi-layered material having graded properties wherein the layers forming the material are made of semiconductor or insulator material which may be amorphous, the layers having a thickness less than an optical wavelength in the material divided by six (6).

Embodiments of the present invention may include multi-layered structures (hereinafter referred to as "super-lattices") with substantially smooth sub-layers, only a few atomic layers thick (5-500A), which can be fabricated from amorphous semiconductors and insulators while simultaneously maintaining their substantially defect-free properties.

In view of the non-equilibrium nature of the growth process and the amorphous surface structure of these thin film amorphous semiconductors, prior to the present invention it was not known whether contiguous layers of different composition, a small number of atomic layers thick, can be deposited with long range ordering, that is over lateral distances large relative to the layer thickness. Furthermore, if an amorphous superlattice material could be fabricated it is not known what the nature of the physical properties of this material would be. For example one of the most basic properties of a material, namely the electronic energy level positions, can be calculated for crystalline semiconductors in terms of band theory which relies on the nearly perfect periodicity of the crystalline structure. In this case, the material properties can in principle be determined from the relevant electronic states and the band structure.

However, in amorphous materials the electronic energy levels cannot be calculated from the theory in the usual way because of the absence of long range periodicity. Although various alternative approaches have been tried with varying degrees of success, generally the theoretical work has at best succeeded only in describing known properties, without successfully predicting novel properties. Thus, it is not known how to predict the physical and chemical properties of an amorphous semiconductor material in which a periodic potential due to the superlattice structure is imposed in addition to the random atomic potentials of the underlying amorphous network.

The amorphous superlattice materials have a variety of uses in optical and electronic applications as in the case of the crystalline superlattice materials. They can be used as antireflection coatings and optical filters.

- 6 -

The invention will be better understood from the following description, given by way of example and with reference to the accompanying drawings, wherein:-

Fig. 1, which has already been briefly described above, shows a schematic energy band diagram for electrons and holes in semiconductor superlattice material, in which the compositional modulation is due to alloying or other gross compositional variation.

Fig. 2, which has also already been briefly described above, shows an energy band diagram for a semiconductor superlattice material in which the compositional modulation is associated with doping.

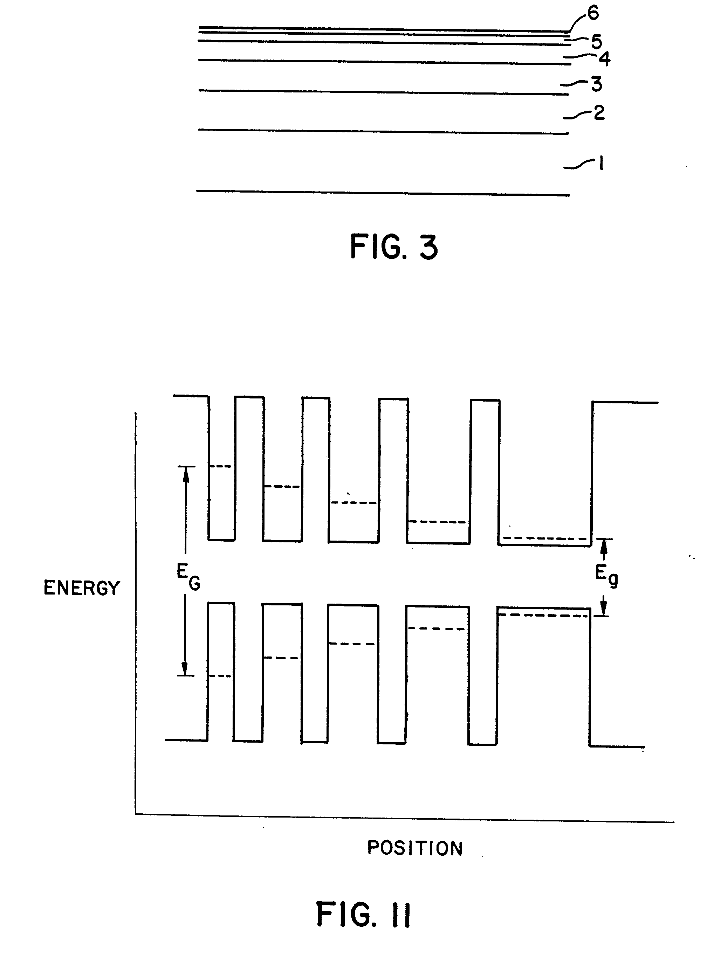

Fig. 3, is a schematic diagram of the composition of one embodiment of the present invention.

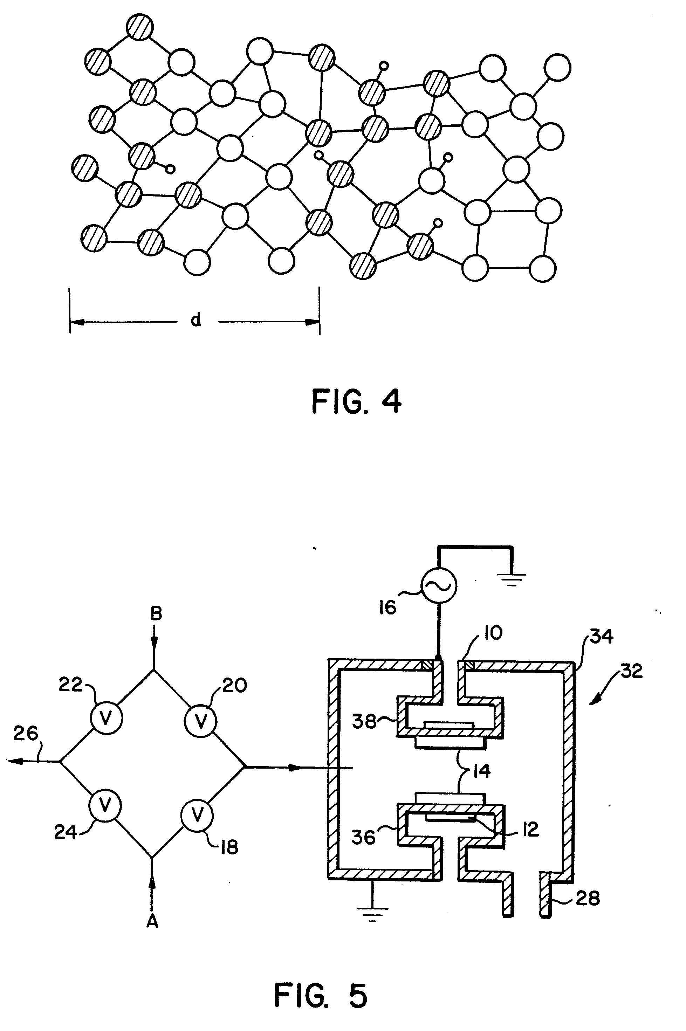

Fig. 4, is a schematic diagram of the position of the individual atoms in the superlattice structure in one embodiment of the present invention.

Fig. 5    is a schematic diagram of a plasma assisted chemical vapor deposition reactor.

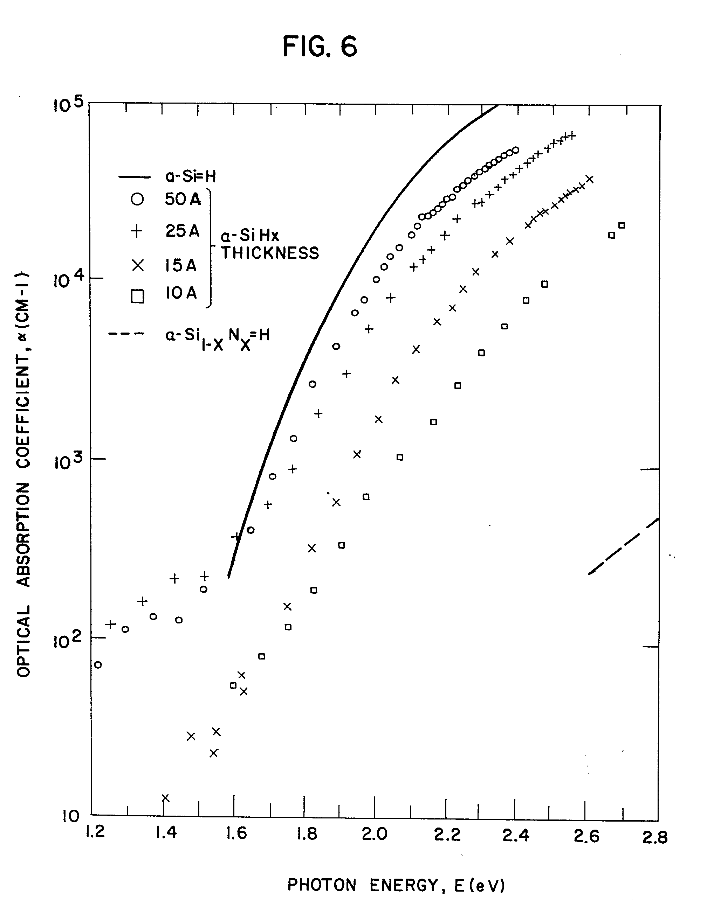

Fig. 6    shows optical absorption coefficient for four $a-Si:H/a-Si_{1-x}N_x:H$ superlattice materials where the $a-Si_{1-x}N_x:H$ sub-layer thickness is held fixed at 35A and the a-Si:H sub-layer thicknesses have the indicated values. Also shown is the optical absorption coefficient of a homogeneous a-Si:H film and a homogeneous $a-Si_{1-x}N_x:H$ film grown under the same conditions as in the superlattice materials.

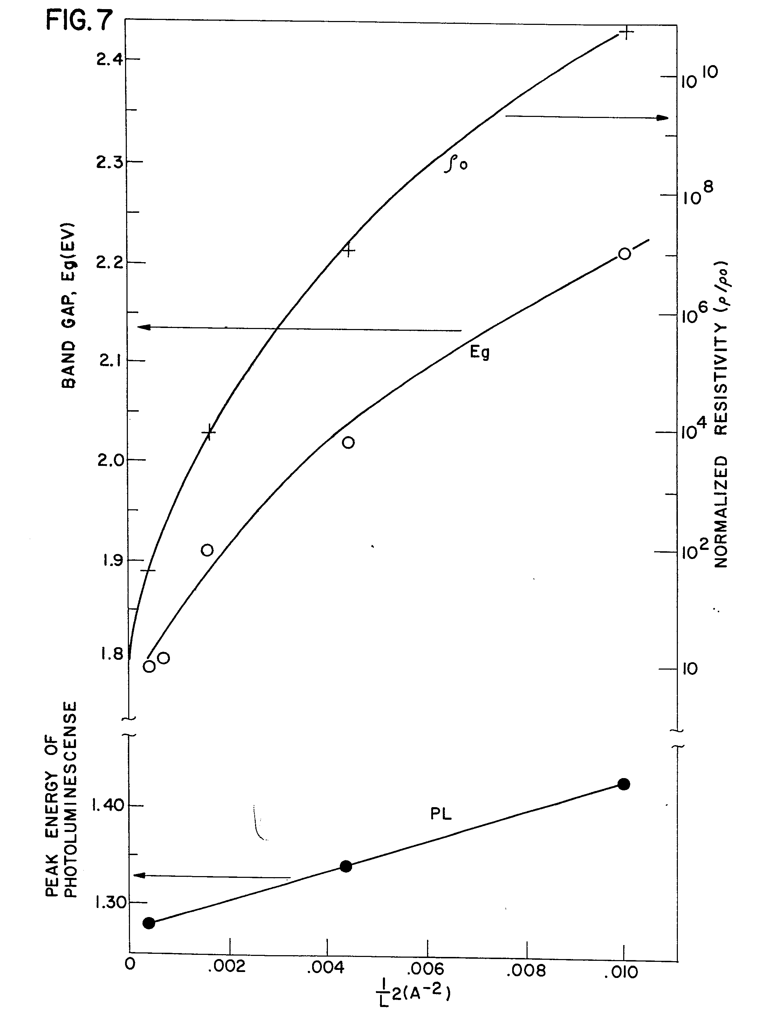

Fig. 7    shows the normalized resistivity , optical gap, $E_g$, and energy of the peak in the photoluminescence emission, PL, as a function of a-Si:H sub-layer thickness L, plotted as $L^{-2}$, for a series of $a-Si:H/a-Si_{1-x}N_x:H$ superlattice materials where the $a-Si_{1-x}N_x:H$ sublayer thickness is held fixed at 35A.

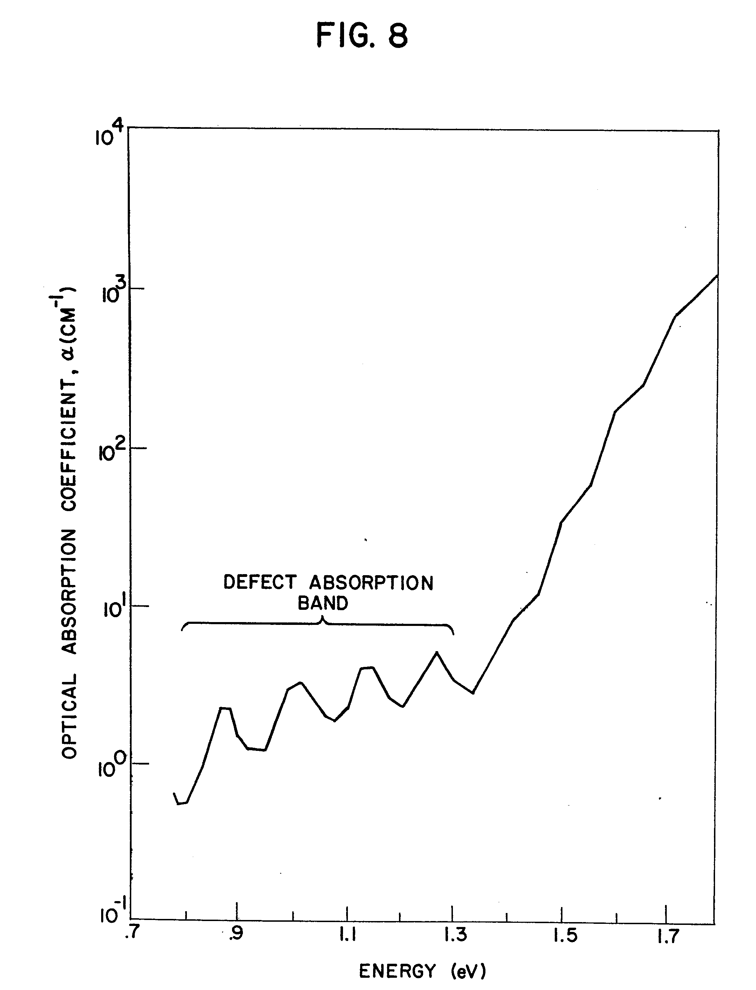

Fig. 8    shows the optical absorption coefficient as a function of photon energy for an amorphous superlattice material comprising about ten periods of 1500A a-Si:H sub-layers and 35A $a-Si_{1-x}N_x:H$ sub-layers. The weakly energy dependent absorption at low photon energies is associated with structural defects.

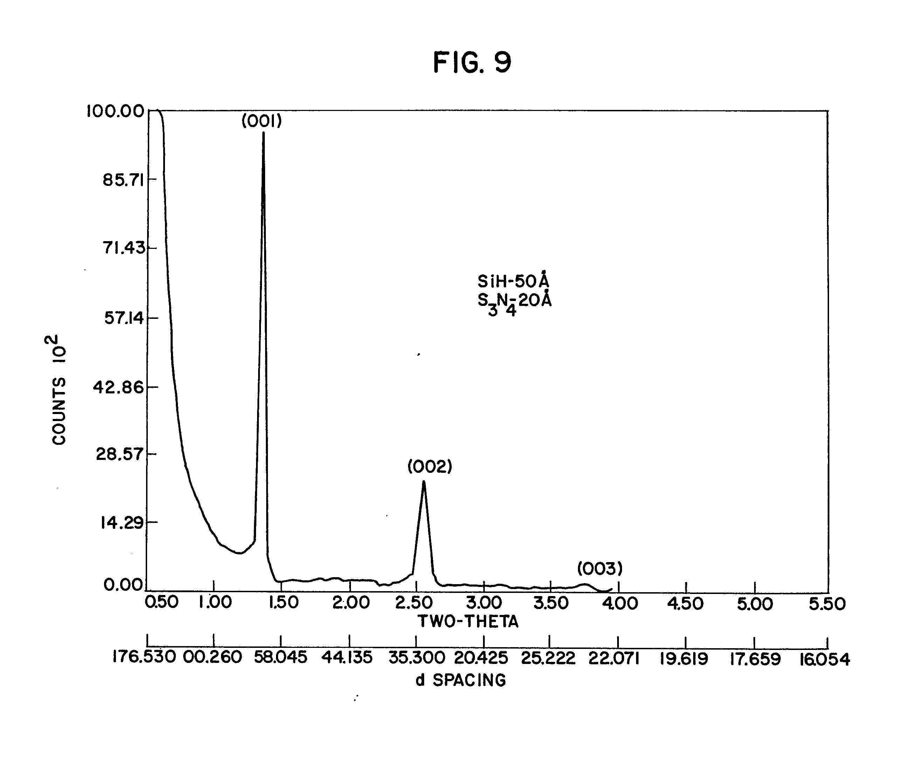

Fig. 9    is a graph of the characteristic X-ray diffraction pattern of a layered amorphous semiconductor superlattice material.

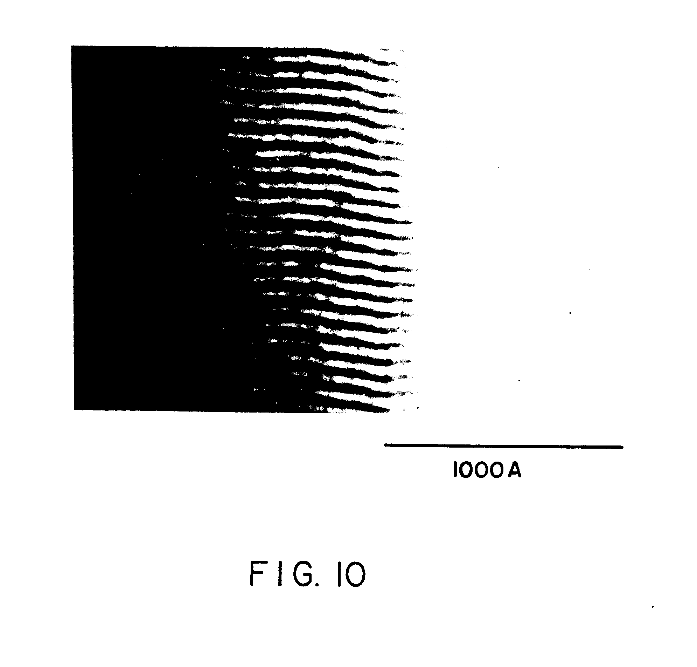

Fig. 10 shows a transmission electron microscope picture of a thin section of an amorphous semiconductor superlattice material wherein the repeat distance is 50A.

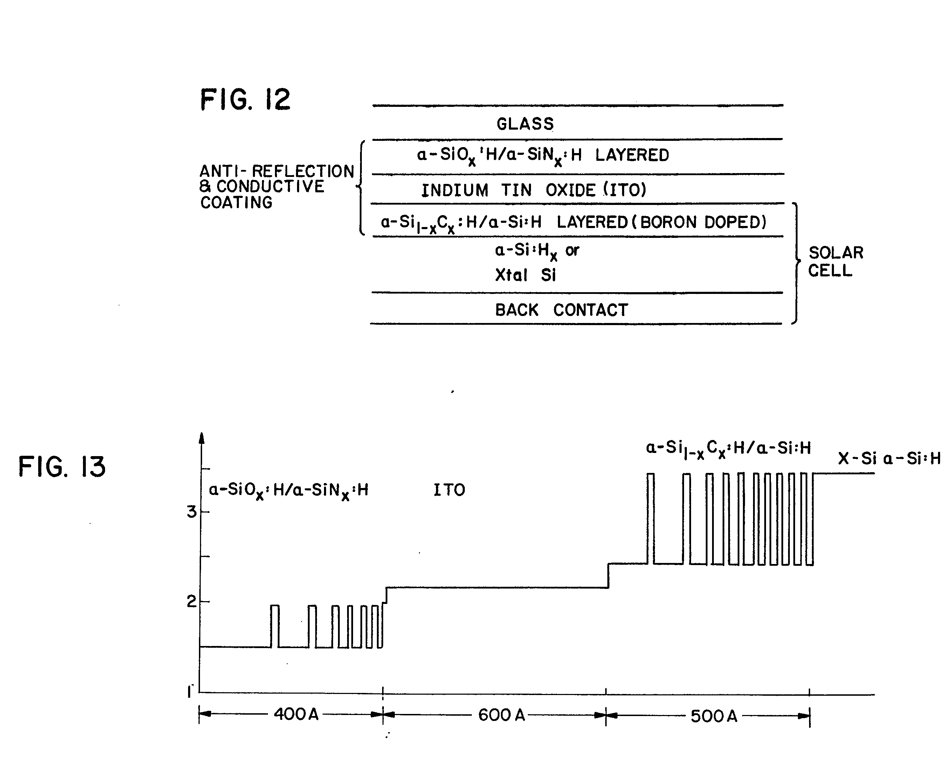

Fig. 11 shows the energy band diagram of a graded optical bandgap material constructed according to the present invention. The dashed horizontal lines represent the positions of the conduction and valence band edges, and show the effect of the quantum confinement on the band edges.

Fig. 12 Amorphous silicon solar cell of a conventional design utilizing an amorphous silicon carbide heterojunction, with a graded multilayer anti-reflection coating designed according to the present invention.

Fig. 13 Internal index of refraction profile for the solar cell anti-reflection and conductive coating shown in Fig. 7.

In putting the present invention into effect, the graded properties may be obtained through variation of the thicknesses of the individual layers in the multilayered material. The gradation of physical properties of the multi-layered material may be a manifestation of the change in the optical gap across the material in a direction perpendicular to the plane of the layers.

The gradation of physical properties may also be a manifestation of an effective medium effect in multi-layered material whose layers have different values for a given physical quantity (i.e., index of refraction) and whose layers have relative thicknesses which vary in a predetermined way to achieve a predetermined average value. In one embodiment, the interfaces between the layers have a thickness less than about 5A. In another embodiment the layers have a thickness less than one sixth of an optical wavelength in the material.

In a preferred embodiment, the graded property is the index of refraction so that the material may be used as an anti-reflection coating.

Fig. 3 shows a schematic diagram of one embodiment of the present invention. The embodiment is a composition of matter which comprises a multilayered material whose layers are thin sheets of semiconducting or insulating tetrahedrally bonded amorphous material. The material has graded properties brought about by the fact that the layers have a spatially varying periodicity. In preferred embodiments, the interface between the layers have a thickness less than about 5A or less than one sixth of an optical wavelength in the material.

In a preferred embodiment, the entire structure is a multilayered thin film material, that is a material that is less than about 10 microns thick, with each layer less than 1000A thick. The first and alternate layers 1, 3, 5 of the structure have the same given composition while the second and alternate layers 2, 4, 6 ... have the same composition different from the given composition of layers 1, 3, 5 ... . That is, layer 3 plus layer 4 is a repeat of the composition of layer 1 plus layer 2, etc. The compositional repeat varies in thickness  so as to grade the properties of the material.

The optical bandgap of the composition may differ from that of materials comprising the individual layers. In a preferred embodiment, the repeat distance is less than 1000A.

A material may be regarded as being homogeneous from the point of view of optical properties as long as the inhomogeneities in composition occur over a length scale small compared to the wavelength of light in the material divided by six (see for example Stephens and Cody, Solar Energy Materials 1, 397 (1979)).  In this case the material may be regarded as a continuum optically, with the optical properties of an equivalent effective medium.  The optical properties of such an effective medium can be graded, by for example changing the density or properties of the inhomogeneous inclusions.

A description of the electronic energy levels in terms of well-defined E vs k relations, where E is the electronic energy and k is its wavevector, is not possible in amorphous semiconductors in the same way as it is in crystalline semiconductors. Nevertheless, some general features of the electronic energy level spectrum are known to be the same in both crystalline and low defect density amorphous semiconductors. For example, both types of semiconductors have a gap in the density of states between a broad distribution of filled levels (the valence band) and a broad distribution of empty levels (the conduction band). In crystals these energy bands have relatively sharp edges, broadened only by the thermal motion of the crystal lattice. In amorphous semiconductors the density of states edges are broader, being broadened by the structural disorder of the amorphous network in addition to the thermal motion of the atoms. The width of the low energy absorption tail of the optical absorption edge is one measure of the sharpness of the band edges in amorphous or crystalline semiconductors. In any case, an objective measure of the position of the band edges can be defined for both crystalline or amorphous semiconductors by, for example, the energy at which the density of.states of the bulk material drops to $10^{20} cm^{-3} ev.^{-1}$ In this sense, energy band diagrams such as those shown in Figs. 1 and 2, as described above can equally well be applied to amorphous and crystalline semiconductors. The modulation in the band edge energies illustrated in Figs. 1 and 2 is obtained by modulation of the thin film composition.

The interfacial regions between the layers of the composition of matter of the present invention are substantially defect free. By substantially defect free we mean that there is less than about one atomic coordination defect at the interface corresponding to an electronic state in the bandgap of the material, per $10^3$ atoms at the interface, taken to be a single monolayer of atoms. This density can be measured by the photothermal deflection technique (see W. Jackson and N. Amer, Physical Review B,25,5559, (1982) and corresponds to an optical absorbance of less than about $10^{-4}$, per interface, in the sub-gap region of the optical absorption spectrum. Referring to Figure 4 shows a schematic diagram of the lattice structure of a periodic superlattice in which the atoms of the alternating layers are indicated by light and dark circles
and hydrogen atoms are indicated by light smaller
circles. The period of the structures is d. As indicated in Figure 4, there are substantially no dangling
bonds to give rise to defects at the interfaces.

Not only are the interfaces between individual layers of the composition
substantially defect free, but they are also smooth and
nearly atomically abrupt. The smoothness and abruptness
of the interfaces can be seen in X-ray diffraction and
transmission electron microscopy (TEM) measurements.
The TEM measurements show that the interfacial region
between layers is < 4A thick.

The interface region is the junction region
between two layers where the composition goes from one
composition to another composition. The compositional
change may be abrupt or continuous. That is, if the
compositions of the adjacent layers are graded, then
the compositional change may be continuous but the rate
of change of the compositional gradation shall change
at the interface.

The X-ray diffraction results require more
extensive interpretation. The result of this interpretation is that the interfacial roughness is 5A which
is believed to be consistent with the TEM measurements,
in light of the assumptions involved in the interpretation of the X-ray data.

The TEM measurements also show that the
interfaces are smooth even after 1 m of material has
been deposited. That is, the interface does not become
progressively more complex and convoluted as the
material grows thicker. This property is unexpected, and differs from the complex growth morphology normally observed in the growth of thin films well below their melting point (see, for example, Thin Film Phenomena, K. L. Chopra, R. E. Krieger Publishing Co., Huntington, NY 1979).

Each individual layer of the composition of the present invention is substantially uniform in thickness. By substantially uniform in thickness, it is meant that the layer thicknesses varies by less than a few monolayers or 10% (whichever is larger) over lateral distances equal to several times the layer thickness.

Examples of amorphous semiconducting and insulating materials that can be fabricated into amorphous semiconductor superlattices according to this invention, can be divided into two classes:

(1)  Group IVA Elements and Alloys include:
a-Si:H, a-Ge:H, $a\text{-}Si_{1-x}C_x\text{:}H$, $a\text{-}Si_{1-x}Ge_x\text{:}H$, $a\text{-}Si_{1-x}\text{-}N_x\text{:}H$, $a\text{-}Si_{1-x}Sn_x\text{:}H$, $a\text{-}Si_{1-x}O_x\text{:}H$, a-C:H (tetrahedrally coordinated) $a\text{-}Si_{1-x-y}O_xN_y\text{:}H$ plus alloys and halogenated (F, Cl) versions of the hydrogenated materials listed. (e.g. $a\text{-}Si_{1-x-y}\,Ge_xSn_y\text{:}H\text{:}F$).

(2)  Group IVA Elements and Alloys Doped with Group IIIA and VA Elements
Suitable n type dopants include N, P, As, Sb, and suitable p type dopants include B, Al, Ga, In, Tl.

- 14 -

As used herein, the subscripts are the atomic fractions of the elements in the material. For example, if $x = 2/3$, then $a\text{-}Si_{1-x}O_x\text{:}H$ is $a\text{-}Si_{1/3}O_{2/3}\text{:}H$ which is $a\text{-}SiO_2\text{:}H$.

Layers 1, 3, 5 ... and layers 2, 4, 6 ... may comprise any two of the materials where both are selected from the same class, e.g. $a\text{-}Si\text{:}H/a\text{-}Si_{1-x}N_x\text{:}H$ or n-doped $a\text{-}Si\text{:}H$/p-doped $a\text{-}Si\text{:}H$.

In addition the alternating layers may include one material from class 1 alternating with a material from class 2, e.g. $a\text{-}Si\text{:}H$/n-doped $a\text{-}Si_{1-x}N_x\text{:}H$.

Preferred compositions also include layered materials of the form n-i-p-i-n-i-p-i, where n and p are n-doped and p-doped material derived from an undoped amorphous semiconductor material, i, by the addition of small concentrations of n and p-type dopant, respectively. In this case, each layer 1, 3, 5 ... is considered to be n-i and each layer 2, 4, 6 ... is considered to p-i so that the spatial repeat distance is the thickness of n-i-p-i.

The composition of matter also includes layered materials where the composition of each layer is modulated across the layers. For example, if the alternating layers are a-Si:H and a-Ge:H alloys, the transition from a-Si:H to a-Ge:H and from a-Ge:H to a-Si:H may occur gradually over the layer thicknesses starting with a-Si:H, gradually increasing the percentage of a-Ge:H until it is all a-Ge:H. In the next adjacent layer, the percentage of a-Si:H is increased until it is all a-Si:H. All succeeding layers repeat this sequence.

- 15 -

The materials in the two groups can be prepared by glow dischange decomposition of gaseous mixtures of volatile hydrides, fluorides or chlorides or of the elemental gases themselves in the case of $O_2$, $N_2$, $Cl_2$ and $F_2$, as described below.

For purposes of description of material preparation and determination of some physical properties (i.e., bandgap variation with layer thickness) of the multi-layered material of the present invention, it is convenient to work with periodic structures. However, these methods and measurement techniques may be applied to non-periodic structures.

Material Preparation

There are several deposition processes that are known to produce low defect density amorphous semiconductors. These include PCVD, low temperature CVD and sputtering. Low temperature CVD is restricted to reactive gases that decompose at relatively low temperature such as for example $Si_2H_6$. Sputtering has the advantage of being capable of producing a wider variety of amorphous semiconductor materials than can be made by PCVD or CVD, however, sputtered films usually contain more defects then PCVD films. We describe here a method for using PCVD to make amorphous semiconductor superlattices. To make amorphous semiconductor superlattices by CVD we simply omit the electric discharge used in the PCVD technique. To make amorphous semiconductor superlattices by sputtering it is possible to modify the technique (A.H. Eltoukhy and I.E. Greene J. Appl. Phys. 50, 505(1979)) for making crystalline semiconductor superlattices by changing the deposition conditions (e.g. substrate temperature, gas pressure and addition of $H_2$ to the plasma discharge) to produce hydrogenated amorphous rather than crystalline semiconductors.

Referring to Fig. 5 a PCVD apparatus for carrying out the fabrication of the material of the present invention is designated as 2. The PCVD apparatus includes a vacuum chamber typically of stainless steel. In the vacuum chamber 4 are electrodes 6 and 8. Electrode 6 is grounded and refered to as the anode. Electrode 8 is insulated from the stainless steel chamber by insulator 10 and is referred to as the cathode. Flat heaters 12 are contained in the electrodes. Substrates 14 which can be insulators such as quartz or metals such as stainless steel are placed in good thermal contact with the electrodes.

The plasma is produced by a low power (5-10 W) RF (13.5 MHz) discharge, by means of an RF generator 16 connected to the cathode. To deposit layered films the composition of the gas in the reactor 2 is changed periodically by opening and closing alternately neumatic valves 18 and 20 to admit gas A or gas B into the reactor.

In order to avoid setting up pressure transients through the opening and closing of valves 18 and 20 the gases A and B are alternatively shunted into a ballast pump 26 by opening and closing valves 22 and 24 in phase with valves 18 and 20, respectively. The gases are pumped continuously out of the reactor by a pump through outlet 28.

To achieve abrupt changes in composition between adjacent layers requires that the time it takes to change gases in the reactor (molecular residence time) be short compared to the time it takes to grow a monolayer. The molecular residence time $\tau_R$ is given by

$$\tau_R = \frac{Vp}{F_0 p_0}$$

where V is the volume of the reactor, p is the gas pressure in the reactor and $F_0$ is the gas flow rate at standard pressure $p_0$. $\tau_R$ can be varied over a wide range of values. In our experiments we have used V = 30 liters, p = 30 m torr, $F_0$ = 0.1 liter/min which gives $\tau_R$ = 1 sec. With a typical deposition rate of 1Å/sec. the transition from one layer to the next takes place over a distance of less than a single atomic layer. The sub layer thickness is given by the product of the deposition rate and the flow period of the gas. The thickness of the sublayers can be varied from a submonolayer to thousands of angstroms.

Example of amorphous semiconductor superlattice that have been produced include:

a-Si:H/a-Ge:H

a-Si:H/a-Si$_{1-x}$N$_x$:H

a-Si:H/a-Si$_{1-x}$C$_x$:H

The a-Si:H sublayers were made from pure SiH$_4$. The Ge:H sublayers were made from a mixture of 10% GeH$_4$ + 90% H$_2$. The a-Si$_{1-x}$C$_x$:H sublayers were made from a mixture of 50% SiH$_4$ + 50% NH$_3$. The a-Si$_{1-x}$N$_x$:H layers were made from a mixture of 20% SiH$_4$ + 80% NH$_3$. The substrate temperatures were in the range 200-250°C.

Amorphous semiconductor n-i-p-i, p-i-p-i, p-n-p-n, n-i-n-i superlattice structures can be formed by any of the methods described above by changing periodically the dopant concentration in the gas. For example by flowing into the reactor first $SiH_4$ + 1% $PH_3$, then $SiH_4$ and then $SiH_4$ + 1% $B_2H_6$ and repeating this sequence periodically we obtain an amorphous semiconductor n-i-p-i superlattice.

The change in the bandgap of the composition of matter of the present invention with layer thickness, is believed to be due to quantum effects brought about by the dimensions of the layered material. The quantum effects also manifest themselves in the electrical properties of the material. The quantum effects brought about by the dimensions of the layered material are expected to have an appreciable effect on the properties of the material only if the energy level shifts introduced by the quantum effect are greater than about kT, where T is the temperature at which the properties are measured ( ~25 mev at room temperature).

Optical Properties

The optical properties of a variety of a-Si:H/a-Si$_{1-x}$N$_x$:H superlattice materials have been investigated. The optical absorption coefficient $\alpha$ as a function of photon energy E is shown in Figure 6 for four different superlattice materials all with the same a-Si$_{1-x}$N$_x$:H sublayer thickness ( ~35A) but with the a-Si:H sublayer thickness varying from about 50A to about 10A. By extrapolating to $\alpha = 0$ a linear fit to the optical absorption data plotted as $(\alpha E)^{1/2}$ as a function of E, where E is the photon energy, as is customarily done in the amorphous semiconductor field to determine optical bandgaps, we found that the optical gap increased by about 0.5 ev when the a-SiH$_x$ sublayer thickness was reduced from 50A to 10A. It is worth noting that the above-mentioned method for determining the optical gap involving extrapolation of $(\alpha E)^{1/2}$ to $\alpha = 0$ is not dependent in any essential way on an accurate knowledge of the thickness of the deposited film.

Also shown in Figure 6 is the optical absorption coefficient for a film comprising only a-Si:H deposited under the same conditions as in the superlattice and a film comprising only $a-Si_{1-x}N_x:H$ also deposited under the same conditions as in the superlattice film. Note that the optical absorption of the superlattice materials cannot be represented as a linear combination of the two constituents. Not only does the magnitude of the optical gap change with a-Si:H sublayer thickness, but also the slope of the low energy exponential part of the absorption edge changes with a-Si:H layer thickness, as illustrated in Fig. 6.

The increase in optical gap for the material with decreasing layer thickness is believed to be associated with the quantum confinement of conduction band electrons into two dimensional potential wells formed by the $a-Si_{1-x}N_x:H/a-Si_{1-x}N_x:H$ sandwiches, as illustrated schematically in Figure 1. In the limiting case that the potential wells are infinitely deep (infinitely large bandgap $a-Si_{1-x}N_x:H$) the optical gap of the superlattice material would be expected to be wider than the optical gap of bulk a-Si:H by $h^2/8m*L^2$ where h is Planck's constant, m* is the effective mass for electrons in a-Si:H and L is the a-Si:H sublayer thickness. Thus, in this interpretation the optical bandgap would be a linear function of $1/L^2$.

A plot of the optical gap $E_g$ as defined above vs. the reciprocal of the square of the a-Si:H sublayer thickness is shown in Figure 7. Note that the optical gap is not a linear function of $1/L^2$ as predicted by the simple theory, rather being sublinear. Nevertheless, the magnitude of the total change in the optical gap with layer thickness is consistent with a physically reasonable electronic effective mass m* (0.1 m < m* $\leq$ 1.0m where m is the free electron mass.)

Also plotted in Figure 7 is the energy of the peak of the photoluminescence emission band for the same superlattice films. Although the energy of the emission peak increases as L decreases, the L dependence is much weaker than the corresponding L dependence for the optical gap also shown in Figure 7. The origin of this difference in behavior is unknown. It could be associated with the fact that a two dimensional excitation is four times more strongly bound than a three dimensional excitation, or it may be simply an indication that the distribution of band tail states is broadened by the two dimensional potential wells introduced by the compositional modulation of the superlattices.

Electrical Properties

The electrical resistivity of a series of a-Si:H/a-Si$_{1-x}$N$_x$:H superlattice materials has been studied, both the resistivity in the plane of the sublayers and the resistivity perpendicular to the sublayers. The resistivity in the plane of the sublayers was determined. The superlattice material was deposited on two predeposited Cr/n+ as-Si:H fingers, through a circular (5mm diameter hole) shadow mask spaced a few tenths of a millimeter above the substrate so as to produce a tapered thickness penumbra few tenths of a millimeter wide around the perimeter of the film. This approach ensures electrical contact to all of the sublayers in the sometimes highly anisotropic superlattice materials. Perpendicular resistivity measurements were performed on films deposited on $Cr/N^+a$-Si:H coated quartz substrates, which forms an ohmic contact to a SiH. A similarly ohmic contact was made to the top surface of the superlattice film with $2mm^2$ area $Cr/n^+a$-Si:H dots.

The room temperature resistivity in the plane of the sublayers is plotted in Figure 7 as a function of $L^{-2}$ for the same series of $a$-Si:H/$a$-Si$_{1-x}$N$_x$:H superlattice materials which had been studied optically. The resistivity in Figure 7 is normalized to the resistivity of the superlattice with the thickest a-Si:H sublayer, which was 1500A thick.

If the Fermi level in the superlattice material remains fixed relative to the edge of the valence band independent of the superlattice size parameter L and the conductivity is due to electrons rather than holes, then the in-plane resistivity is expected to depend on the band gap through the exponential relation $\rho = \rho_0 \exp(E/kT)$. Provided the optical gap is a good measure of the band gap, a plot of $kT \ln \rho/\rho_0$ as a function of $1/L^2$ should parallel the optical gap. The logarithmic resistivity scale on the right hand vertical axis in Figure 3 has been appropriately scaled so that $KT \ln \rho/\rho_0$ in electron volts corresponds to the energy scale in electron volts for the optical gap on the left hand vertical axis.

- 22 -

Note that the resistivity increases more rapidly with decreasing superlattice parameter L than expected on the basis of the optical gap alone.

One speculative explanation for the difference between the optical gap and the gap inferred from the resistivity, is that the mobility gap, which is the relevant quantity as far as the resistivity is concerned, increases more rapidly with the two dimensional quantum confinement, than the density of states gap.

The anisotropy in the electrical resistivity, of the $a\text{-Si:H}/a\text{-Si}_{1-x}N_x\text{:H}$ superlattice materials namely the ratio of the perpendicular resistivity to the in-plane resistivity, varied from $> 10^8$ for the thick a-Si:H sublayer material to order 10-100 in the thin a-Si:H sublayer material. The larger anisotropy for the large L material where L is the thickness of the a-Si:H sublayers ($a\text{-Si}_{1-x}N_x\text{:H}$ sublayer held at 35A) confirms the x-ray structural results, namely that thin, laterally coherent amorphous films have been fabricated. The reduction in anisotropy for the small L material results from the much larger in-plane resistivity in this material.

Density of Defects

The magnitude of the optical absorption coefficient for photon energies less than the optical absorption threshold is a commonly used figure of merit in the characterization of the defect density in semiconductor materials. In a-Si:H, it is well-known that structural defects such as dangling bonds show up as a low energy absorption shoulder whose magnitude is proportional to the density of defects. The optical absorption coefficient in the weakly absorbing subband- gap region is most easily determined from the photoconductivity response spectrum as measured using the
technique of Triska et al. (Sol. State Commun. 1981)
for example. The absolute magnitude of the low energy
absorption is then determined by a match of the high
energy part of the photoconductivity spectrum to optical transmission measurements.

The optical absorption coefficient $\alpha$ deter-
mined as outlined above for photon energies in the
vicinity of the optical gap and lower, is shown in
Figure 8 for an amorphous semiconductor superlattice
material comprising alternating 1500A a-Si:H layers and
35A a-Si$_{1-x}$N$_x$:H layers. The oscillations in the optical
absorption are caused by interference fringes generated
by reflections at the film-substrate interface and the
film-air interface. The optical absorption coefficient
for the bulk material is the average of the interference maxima and minima on a logarithmic scale.

The optical absorption at 1.2 ev of about 3
cm$^{-1}$ in Figure 8, is equivalent to a density of defect
states of order 10$^{16}$ cm$^{-3}$/ev, which corresponds to
approximately one defect in 10$^7$ atoms. This defect
density is comparable to the defect density in conventional nominally homogeneous a-Si:H films prepared
under the same conditions.

X-Ray Properties

An important test of the structural perfection of layered amorphous semiconductors is the
ability of periodic layered amorphous semiconductors
to diffract x-rays. The layered films act as a one
dimensional diffraction grating, giving rise to character-
stic diffraction according to Bragg's law:

$$2d \sin \emptyset_m = m \lambda$$

where $\emptyset$ is the Bragg angle corresponding to the $m^{th}$ order diffraction, d is the repeat distance of the superlattice and $\lambda$ is the wavelength of the x-ray.

In Figure 9 is shown the characteristic diffraction pattern of an amorphous semiconductor superlattice consisting of 40 periods deposited on a quartz substrate. Each period consists of a 40Å thick sublayer of a-Si:H/a-Si$_{1-x}$N$_x$:H and a 30Å thick sublayer of a-Si$_{1-x}$N$_x$:H. The X-ray measurements were made with $\lambda = 1.54$Å. The sharpness of the peaks and the magnitude of the higher order reflections provide evidence that the layers are of uniform thickness, smooth and parallel.

In the case of the perfectly smooth and parallel layers the magnitude of the m order reflection, R, is given by (see, e.g., J. H. Underwood and T. W. Barber P. 170 of the proceedings of the AIP in conference (1981))

$$R_m = (constant) \frac{\left[ \sin\left( \frac{md_1 \pi}{d} \right) \right]^2}{m^4}$$

where $d_1$ and $d_2$ are the thickness of the two sublayers forming the superlattice ($d = d_1 + d_2$). If the layers are rough then the higher harmonics are attenuated according to the expression

$$R'_m = R_m \exp \left[ -\left( \frac{Lm\,\pi}{d} \zeta \right)^2 \right]$$

$$- 25 -$$

where $R'_m$ is the mth order reflection for the rough superlattice and $\zeta$ is the RMS roughness of the interfaces. By applying the above two equations to our x-ray data we obtain an RMS roughness $\zeta = 5\overset{o}{A}$ which is about two monolayers.

## TRANSMISSION MICROSCOPY

Another way of checking the perfection of the superlattice is by transmission electron microscopy of a thin section perpendicular to the interfaces.

Referring to Fig. 10 shows a transmission electron microscope picture of a layered a-Si:H/a-Si$_{1-x}$N$_x$:H amorphous semiconductor superlattice material with a periodic repeat distance of about $50\overset{o}{A}$/ This figure further demonstrates the existence of nearly atomically abrupt and substantially smooth interfaces.

During the foregoing description of some of the preferred embodiments of the present invention, interpretations have been given for some of the results contained herein. These interpretations are given for purposes of illustration and which are in no way intended to limit the scope of the invention, as defined by the appended claims.

Graded Optical Gap

In a preferred embodiment, where multilayer material consists of alternating layers of hydrogenated amorphous silicon (a-Si:H) and hydrogenated amorphous silicon carbide (a-SiC:H) the optical bandgap of the material begins to increase above that of conventional unlayered a-Si:H films, prepared under the same conditions, when the a-Si:H layers are less than about 30A thick.

As an example of a graded optical bandgap superlattice material, refer to Fig. 11 for a specific case. Fig. 11 shows a schematic diagram of the band diagram for the above-described material wherein energy is plotted vs. distance. Consider a material in which the composition is the same as a mixture of equal parts of a-Si:H and a-SiC:H, grown with the following layered structure. The first layer consists of 30A of a-Si:H, the next layer 29A of a-SiC:H, the next 28A of a-Si:H, followed by 27A of a-SiC:H etc... finished with 5A of a-SiC:H. This material will have an optical gap, $E_g$, of about 1.7 ev corresponding to a-Si:H and an optical gap, $E_G$, of about 1.95 ev corresponding to the mean bandgap, halfway between a-Si:H (1.7 ev) and a-SiC:H (typical value 2.2 ev). Materials with graded optical bandgaps of this type are useful in vidicon-type image pick-up tubes as described by Hirai and Maruyama in Chapter 6 of Japan Annual Reviews in Electronics Computers and Telecommunications, Amorphous Semiconductor Technologies and Devices, North Holland, ed. by Y. Hamakawa, 1982.

By internal optical gap, we mean an optical gap as determined by a probe of the electronic structure that is only sensitive to a 20-30A thick surface layer, such as UV photoemission, as discussed by L. Ley in Topics in Applied Physics, Vol. 56, The Physics of Hydrogenated Amorphous Silicon II, ed. J. D. Joannopoulos and G. Lucovsky, Springer Verlag 1984, for example.

## Antireflection Coating

Another application of graded superlattice materials is antireflection (AR) coatings. An AR coating is an essential element of any efficient solar cell. For example, a single layer 550A n=2.2 antireflection coating on an amorphous silicon solar cell increases the current by more than 50% over an uncoated cell (C. R. Wronski et al., 15th IEEE PVSC, May 1981). Although a single layer coating reduces the reflectivity, a substantial fraction of the potentially useful light is still reflected. The reason is that an optimum single layer AR coat is a resonant structure which performs well only at wavelengths close to 4D where D is the layer thickness.

In amorphous silicon solar cells, for example, the short circuit current with a single layer AR coating is about 15% less than it would be with a perfect AR coating (B. Abeles et al., Thin Solid Films 90, 441, 1982). The difference will be somewhat larger in amorphous silicon solar cells with an extended spectral response ("optical enhancement"). In principle, the single layer AR coat should be even more deficient in the case of crystalline silicon solar cells because of the relatively wider spectral response (400-1000 nm vs. 400-700 nm for a-Si). However, in practice, surface texturing introduced by the wafer sawing operation and index grading associated with encapsulated and dopant diffusion in conventional crystalline silicon cells, combine to reduce the net reflectivity to 8-10%.

To reduce reflection losses, a new form of graded index anti-reflection coating based on plasma CVD deposited graded superlattice structures is shown schematically in Fig. 12. One deposits high and low index materials in layers that are thinner than an optical wavelength so that they act as an effective medium with an index intermediate between the indices of the two constituents. By changing the spacing of the high index layers, for example, one can grade the index and obtain a coating with spectrally flat anti-reflection properties. The schematic diagram of Fig. 7 shows a particular example for the constituent elements of the solar cell. It is understood that other multi-layered materials may be used.

A suitable amorphous silicon or crystalline silicon heterojunction solar cell structure which utilizes the layered AR coatings is illustrated in Fig. 12 and the corresponding index of refraction profile in Fig. 3. In addition to the obvious advantage of reducing the reflection losses, both at normal incidence and oblique incidence, the layered structures in Fig. 12 and Fig. 13 have other advantages:

1. By grading into the n=2.2 ITO layer and from the ITO layer to the silicon layer, the ITO layer no longer needs to function as an AR coat itself. Hence, it can be made as thick as necessary to satisfy the conductivity requirements.

2. The layered structures offer a uniquely controllable method for grading the index that simplifies coating design and process control.

3. The index of refraction can be controlled independently without sacrificing the optimization of other relevant properties such as chemical stability, optical transparency or mechanical properties.

0173566

CLAIMS:

1.      A multilayered material, for example with non-periodic layers, having graded properties wherein the layers forming the material are made of semiconductor or insulator material, which may for example be amorphous, the interfaces between said layers being smooth and having a thickness less than about 500A, for example less than about 5A.

2.      A material according to claim 1, wherein said layers have a thickness less than an optical wavelength in the material divided by six (6).

3.      A material according to claim 1 or 2, wherein successive layers of said multi-layered material are denoted 1, 2, 3, 4, 5, 6 ... and wherein said 1, 3, 5, ... layers have one index of refraction and said 2, 4, 6, ... layers have another index of refraction.

4.      A material according to any preceding claim, wherein successive layers of said multi-layered material are denoted 1, 2, 3, 4, 5, 6, ... and wherein said 1, 3, 5, ... layers have one bandgap and 2, 4, 6, ... layers have smaller bandgap, said layers being sufficiently thin to produce quantum wells in said material, said bandgap layers having different thicknesses such that the minimum available energy state available to the conduction electrons varies according to said thickness.

5.      A material according to any preceding claim, wherein said interfaces are substantially defect free.

6. A material according to any preceding claim, wherein said layers are substantially smooth and of substantially uniform thickness laterally across each layer.

7. A material according to any preceding claim, wherein the first and successive alternate layers of said multi-layered structure have the same given composition and the second and successive alternate layers of said structure have the same composition different from said given composition.

8. A material according to any preceding claim, wherein said first and successive alternate layers comprise a tetrahedrally bonded element from Group IVA of the periodic table, or an alloy containing said tetrahedrally bonded elements.

9. A material according to any preceding claim, wherein said first and successive alternate layers are a-Si:H and said second and successive alternate layers are a-Ge:H.

10. A material according to any preceding claim, wherein said first and successive alternate layers are $Si_{1-x}O_x$:H and said second and successive alternate layers are a-$Si_{1-x}N_x$:H.

FIG. 1

FIG. 2

FIG. 3

ENERGY

$E_G$

$E_g$

POSITION

FIG. II

FIG. 4

FIG. 5

FIG. 6

FIG.7

0173566

# FIG. 8

FIG. 9

1000 A

FIG. 10

# FIG. 12

| GLASS |
|---|

**ANTI-REFLECTION & CONDUCTIVE COATING** {

| $a\text{-}SiO_x\text{'H}/a\text{-}SiN_x\text{:}H$ LAYERED |
|---|
| INDIUM TIN OXIDE (ITO) |

| $a\text{-}Si_{1-x}C_x\text{:}H/a\text{-}Si\text{:}H$ LAYERED (BORON DOPED) | } **SOLAR CELL** |
|---|---|
| $a\text{-}Si\text{:}H_x$ or Xtal Si | |
| BACK CONTACT | |

# FIG. 13

$a\text{-}SiO_x\text{:}H/a\text{-}SiN_x\text{:}H$   ITO   $a\text{-}Si_{1-x}C_x\text{:}H/a\text{-}Si\text{:}H$   X-Si $a\text{-}Si\text{:}H$

3

2

1

|← 400 A →|← 600 A →|← 500 A →|